# EUROPÄISCHE PATENTSCHRIFT

(11) **EP 1 177 570 B1**
(45) Veröffentlichungstag und Bekanntmachung des Hinweises auf die Patenterteilung: **13.02.2008**
(21) Anmeldenummer: 00926908.5
(22) Anmeldetag: 13.04.2000
(51) Int. Cl.: H01L 21/00

(54) **EINRICHTUNG ZUM HANDHABEN VON SUBSTRATEN INNERHALB UND AUSSERHALB EINES REINSTARBEITSRAUMES**
DEVICE FOR HANDLING SUBSTRATES INSIDE AND OUTSIDE A CLEAN ROOM
DISPOSITIF POUR LA MANIPULATION DE SUBSTRATS A L'INTERIEUR ET A L'EXTERIEUR D'UN ESPACE DE SALLE BLANCHE

(30) Priorität: 08.05.1999 DE 19921072
(43) Veröffentlichungstag der Anmeldung: 06.02.2002
(73) Patentinhaber: BROOKS Automation GmbH, 07745 Jena (DE)
(72) Erfinder: SCHMUTZ, Wolfgang, D-78658 Zimmern (DE); GENTISCHER, Josef, D-73630 Remshalden (DE)
(74) Vertreter: Bertram, Helmut
(86) Internationale Anmeldenummer: PCT/EP2000/003324
(87) Internationale Veröffentlichungsnummer: WO 2000/068976

(56) Entgegenhaltungen:
- WO-A-99/02436
- WO-A-99/28951
- US-A- 5 788 447

## Beschreibung

Die vorliegende Erfindung bezieht sich auf eine Einrichtung zum Handhaben von Substraten innerhalb und außerhalb eines Reinstarbeitsraumes nach dem Oberbegriff des Anspruches 1.

Bei bisher bekannten Einrichtungen dieser Art werden dem Reinstarbeitsraum manuell oder automatisch die einzelnen Kassettenboxen zugeführt, worauf die Substrate innerhalb des Reinstarbeitsraumes bearbeitet werden; danach werden die mit den bearbeiteten Substraten versehenen Kassettenboxen zu einer weiteren vom Reinstarbeitsraum entfernt angeordneten Station geführt. Die Anordnung verschiedener Stationen einer derartigen Einrichtung ist platzaufwendig und durch die zwischen den Stationen anzuordnenden Handhabungsvorrichtungen zeit- und kostenaufwendig.

Die US 5 788 447 A sieht zur Substratumsetzung zwischen einem Lager und einer Vielzahl von Bearbeitungskammern einen Transportroboter vor, der an einem vertikal verstellbaren Liftelement befestigt ist, das über ein Dichtglied in eine Übertragungskammer zwischen dem Lager und den Bearbeitungskammern geführt ist.

Eine aus der WO 99/02436 A1 vorbekannte Einrichtung weist an einer Rückwand eine Vielzahl von Fächern für einen oder mehrere Wafertransportbehälter auf, zu deren Umsetzung ein zweidimensionales Transportsystem vorgesehen ist. Dadurch, dass jeglicher Transport der Behälter in einer Ebene erfolgt, wird ein schmaler Systemaufbau realisiert.

Aufgabe der vorliegenden Erfindung ist es, eine Einrichtung zum Handhaben von Substraten innerhalb und außerhalb eines Reinstarbeitsraumes der eingangs genannten Art zu schaffen, die in platzsparender Weise verschiedene Arbeits- und Produktionsschritte zu kombinieren in der Lage ist.

Zur Lösung dieser Aufgabe sind bei einer Einrichtung zum Handhaben von Substraten innerhalb und außerhalb eines Reinstarbeitsraumes der eingangs genannten Art die im Anspruch 1 angegebenen Merkmale vorgesehen.

Da der Lagerraum über dem sonst ungenutzten Reinstarbeitsraum angeordnet ist, ist in platzsparender Weise eine Einrichtung zum Handhaben von Substraten innerhalb und außerhalb des Reinstarbeitsraumes geschaffen, die die unterschiedlichsten Arbeitsschritte in sich vereinigen bzw. kombinieren kann. Da die Wege kurz sind, ergibt sich eine erhebliche Zeitersparnis.

In idealer Weise können die Substratkassetten beliebiger Kassettenboxen in den Reinstarbeitsraum gebracht, bearbeitet oder in anderer Weise gehandhabt werden und in gleicher oder neuer Zuordnung zueinander in einer Kassettenbox wieder abgelegt und bspw. neu sortiert gelagert werden.

Weitere Arbeitsschritte und zeitsparende Kombinationen von Arbeitsschritten sind dann möglich, wenn die Merkmale gemäß Anspruch 2 vorgesehen sind.

Vorteilhafte Ausgestaltungen der Schleuseneinheiten der Schleusenvorrichtung ergeben sich durch die Merkmale eines oder mehrerer der Ansprüche 3 bis 7.

Zur einfachen Handhabung der Substratkassetten bzw. Kassettenboxen sind gemäß den Merkmalen des Anspruchs 8 ein oder mehrere Hubwerke vorgesehen.

Gemäß den Merkmalen des Anspruchs 9 können innerhalb des Reinstarbeitsraumes die unterschiedlichsten Arbeitsschritte einzeln oder in Kombination vorgenommen werden, wie bspw. Prozeßvorgänge, Fertigungsvorgänge, Prüfvorgänge und Sortiervorgänge. Entsprechend den Prüf- und/oder Sortiervorgängen können dadurch auch neue Lose von Substraten zusammengestellt und im Lagerraum abgelegt werden. Hierzu ist die gemäß den Merkmalen des Anspruchs 10 ausgebildete erste Handhabungsvorrichtung von besonderem Vorteil.

Der Lagerraum ist mit einer Vielzahl von Lagerplätzen versehen, welche zusammen mit der oder den Schleuseneinheiten und zusammen mit einer oder mehrerer Ein-/Ausgangsöffnungen für die Kassettenboxen gemäß Anspruch 12 durch die zweite Handhabungsvorrichtung erreichbar sind. Vorteilhafte Ausgestaltungen hierzu ergeben sich durch die Merkmale eines oder mehrerer der Ansprüche 11 und 13 bis 15.

Weitere Einzelheiten der Erfindung sind der folgenden Beschreibung zu entnehmen, in der die Erfindung anhand der in der Zeichnung dargestellten Ausführungsbeispiele näher beschrieben und erläutert sind. Es zeigen:
- Figur 1: in schematischer quergeschnittener Darstellung eine Einrichtung zum Handhaben von Substraten innerhalb und außerhalb eines Reinstarbeitsraumes gemäß einem bevorzugten Ausführungsbeispiel vorliegender Erfindung,
- Figur 2: eine teilweise aufgebrochene Seitenansicht gemäß Pfeil II der Figur 1 und
- Figur 3: eine der Figur 1 entsprechende Darstellung, jedoch gemäß einem anderen Ausführungsbeispiel vorliegender Erfindung.

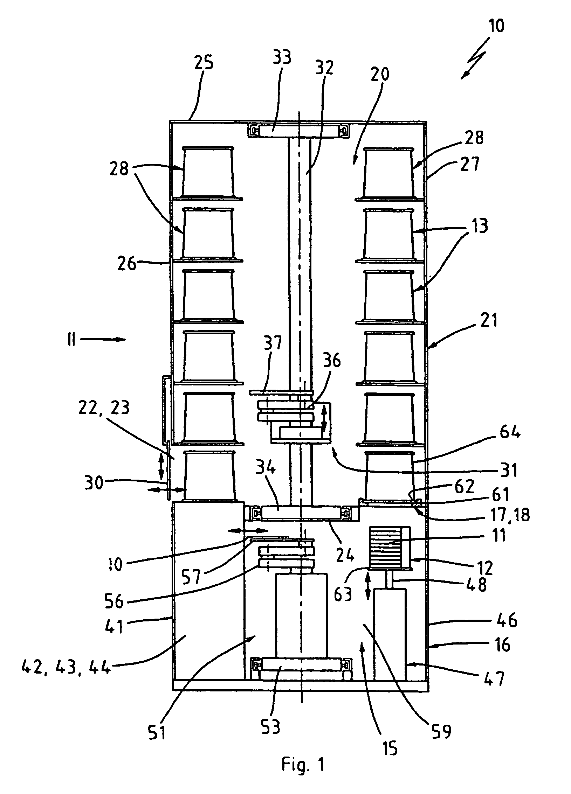

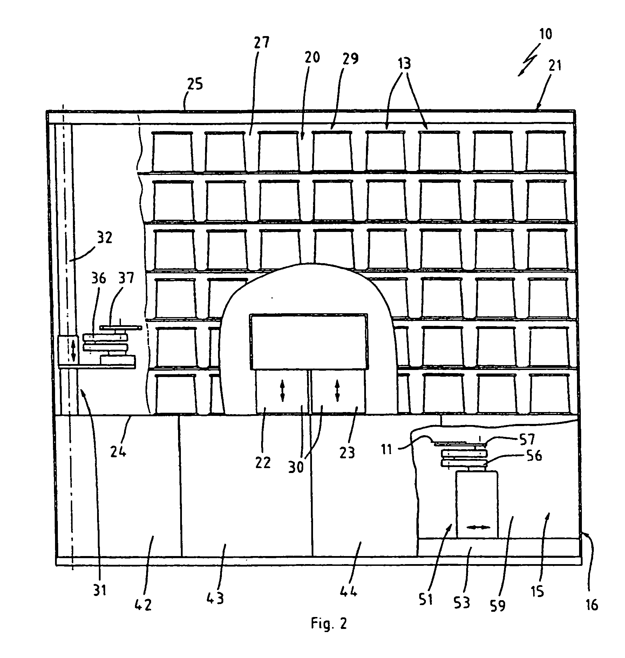

Die in den Figuren 1 und 2 gemäß einem bevorzugten Ausführungsbeispiel vorliegender Erfindung dargestellte Einrichtung 10 dient zum Handhaben von Substraten 11 innerhalb und außerhalb eines Reinstarbeitsraumes 15, wobei die Substrate 11 in einer Kassette 12 übereinandergestapelt untergebracht sind und jede Kassette 12 unter Reinstraumbedingungen innerhalb einer Box 13 angeordnet werden.

Der Reinstarbeitsraum 15 besitzt ein bspw. etwa quaderförmiges Gehäuse 16, das hermetisch abgeschlossen ist und eine Schleusenvorrichtung 17 mit einer oder mehreren Schleuseneinheiten 18 aufweist. Auf das Gehäuse 16 des Reinstarbeitsraumes 15 ist ein Gehäuse 21 aufgesetzt, das einen Lagerraum 20 beinhaltet bzw. begrenzt. Die Schleusenvorrichtung 17 schafft einen Handhabungsübergang ohne "Klima"-Austausch zwischen dem Lagerraum 20 und dem Reinstarbeitsraum 15. Der Lagerraum 20 ist mit einer oder mehreren mittels einer Tür 30 verschließbaren Ein-/Ausgabeöffnungen 22, 23 zum Zuführen bzw. Entnehmen von Kassettenboxen 13 versehen. Beim dargestellten Ausführungsbeispiel sind zwei nebeneinander angeordnete Ein-/Ausgabeöffnungen 22 und 23 nahe dem Boden 24 des Gehäuses 21 vorgesehen. Es versteht sich, dass die Ein-/Ausgabeöffnungen 22, 23 in größerer Vielzahl vorhanden und/oder an anderen Stellen des Gehäuses 21, bspw. nahe dessen Decke 25, vorgesehen sein können. Dies hängt u.a. auch davon ab, ob die Ein-/Ausgabeöffnungen 22, 23 manuell oder automatisch mittels einer Beschickungseinrichtung bedient werden.

Das Gehäuse 21 des Lagerraums 20 ist beim dargestellten Ausführungsbeispiel quaderförmig und dabei relativ hoch und derart, dass längs beider Längsseitenwände 26 und 27 Reihen und Spalten von Lagerplätzen 28 für Kassettenboxen 13 vorgesehen sind. Zwischen den beiden Lagerplatzanordnungen 28 und 29 ist eine Handhabungsvorrichtung 31 für die Kassettenboxen 13 vorgesehen. Die Handhabungsvorrichtung 31 besitzt eine aufrechte Säule 32, die im Boden 24 und in der Decke 25 des Gehäuses 21 über eine Linearführung 33, 34 längsgeführt ist. In vertikaler Richtung ist an der Säule 32 eine horizontal bewegbare Knickarmgabel 36 geführt, mit deren Gabelende 37 die Kassettenboxen 13 bspw. obenseitig untergriffen werden können. Die Handhabungsvorrichtung 31 ist somit in den drei Koordinatenachsen bewegbar, so dass Kassettenboxen 13 von der oder den Ein-/Ausgabeöffnungen 22, 23 zu den Lagerplätzen 28, 29 und zurück und zwischen den Lagerplätzen 28, 29 und den Schleuseneinheiten 18 der Schleusenvorrichtung 17 bewegt werden können.

Innerhalb des Gehäuses 16 für den Reinstarbeitsraum 15 sind an einer Längsseite 41 des Gehäuses 16 mehrere Kammern 42, 43, 44 bspw. nebeneinander angeordnet. Bei diesen Kammern 42 bis 44 kann es sich um Prozeßkammern, Fertigungskammern, Prüfkammern, Identifizierungskammern und/oder dgl. handeln. Es versteht sich, dass unabhängig von der zeichnerischen Darstellung eine beliebige Vielzahl von Kammern vorgesehen sein kann. An der gegenüberliegenden Längsseite 46 des Gehäuses 16 für den Reinstarbeitsraum 15 ist bzw. sind eine oder mehrere Hubvorrichtungen 47 vorgesehen, die im Bereich bzw. unterhalb der Schleuseneinheiten 18 der Schleusenvorrichtung 17 angeordnet und jeweils einer dieser zugeordnet sind. Die Hubvorrichtung 47 besitzt eine auf- und abbewegbare Stange 48, mittels der eine Substratkassette 12 auf und ab bewegbar ist.

Zwischen der Anordnung der Kammern 42 bis 44 auf der einen Längsseite 46 und der Anordnung einer oder mehrerer Hubvorrichtungen 47 auf der anderen Längsseite 46 ist eine Handhabungsvorrichtung 51 vorgesehen, die auf einer bodenseitigen Linearführung 53 in Längsrichtung des Gehäuses 16 hin und her verfahrbar ist. Die Handhabungsvorrichtung 51 besitzt beim dargestellten Ausführungsbeispiel einen horizontal bewegbaren Knickarmgreifer 56, mit dessen Greiferende 57 die Substrate 11 zwischen den auf der Hubvorrichtung 47 aufliegenden Substratkassetten 12 einerseits und einer oder mehrerer der Kammern 42 bis 44 transportiert werden können.

Beim Ausführungsbeispiel der Figuren 1 und 2 ist bzw. sind die Schleuseneinheiten 18 der Schleusenvorrichtung 17 am Boden 24 des Gehäuses 21, der hier eine Zwischenwand der Gehäuse 16 und 21 bildet, unmittelbar über der Anordnung der Hubvorrichtung bzw. Hubvorrichtungen 47 vorgesehen. Die Schleuseneinheit 18 besitzt eine umlaufende Auflage 61, auf der der untere Rand 62 einer Haube 64 jeder Kassettenbox 13 dichtend aufsetzbar ist. Zur schleusenartigen Einführung der Substratkassette 12 in den Reinstarbeitsraum 15 wird der Kassettenboden 63 von der Haube 64 der Kassettenbox 13 entriegelt, von der Stange 48 der Hubvorrichtung 47 aufgenommen und aus der Kassettenbox 13 heraus in die Höhe der Handhabungsvorrichtung 51 abgesenkt, so dass die Substrate 11 der Kassette 12 gehandhabt werden können. Sind mehrere Hubvorrichtungen 47 bei mehreren Schleuseneinheiten 48 und somit mehreren gleichzeitig oder nacheinander zu handhabenden Substratkassetten 12 innerhalb des Reinstarbeitsraumes 15 vorgesehen, können die einzelnen Substratkassetten 12 in unterschiedlicher Weise neu bestückt werden, so dass neue Lose zusammengestellt werden können. Das Zurückführen einer Substratkassette 12 in ihre Kassettenbox 13 erfolgt in entsprechend umgekehrter Weise mittels der Hubvorrichtung 47, worauf nach Verriegelung des Kassettenbodens 63 mit der Haube 64 die Kassettenbox 13 von der Schleuseneinheit 18 zu einem Lagerplatz 28, 29 oder zu einer Ein-/Ausgabeöffnung 22, 23 mittels der Handhabungsvorrichtung 31 gebracht werden kann.

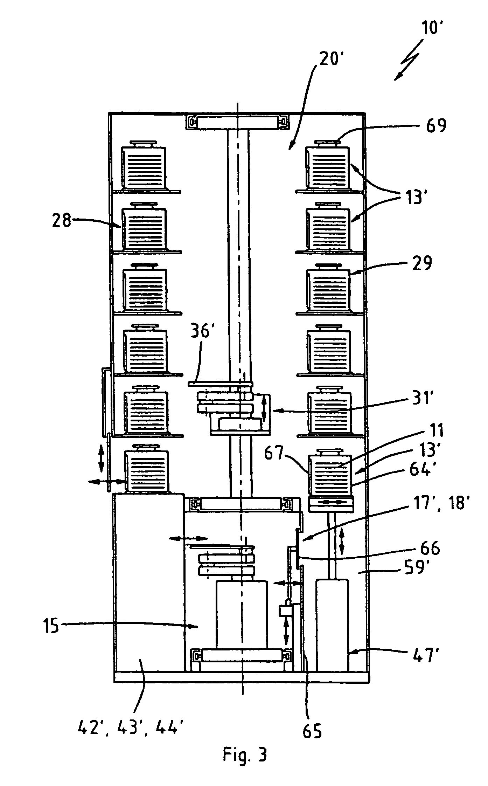

Beim in Figur 3 dargestellten Ausführungsbeispiel der Einrichtung 10' ist der Ort 59', an dem sich die Hubvorrichtung bzw. -vorrichtungen 47' befindet bzw. befinden, zwar ebenfalls nahe einer Gehäuselängsseite, jedoch noch innerhalb des Lagerraums 20', und damit außerhalb des Reinstarbeitsraumes 15, dessen nach innen versetzte Seitenwand 65 einen Teil der Schleusenvorrichtung 17' bzw. der einen oder mehreren Schleuseneinheiten 18' bildet. Bei diesem Ausführungsbeispiel wird eine komplette Kassettenbox 13' mit Hilfe der Handhabungsvorrichtung 31' auf die Hubvorrichtung 47' gebracht und mit Hilfe dieser in den Bereich der Seitenwand 65 bzw. deren Schleuseneinheit 18' abgesenkt. Die Hubvorrichtung 47' ist damit als absenkbarer Lagerplatz 29 ausgebildet.

In der Seitenwand 65 befinden sich entsprechende Anzahl Schleuseneinheiten 18' entsprechend viele Schleusentüren 66, von denen jede zusammen mit einer Seitentür 67 in der Kassettenbox 13' dann geöffnet wird, wenn die Kassettenbox 13' in gegenüber dem Lageraum 20' abdichtender Weise um die Schleusentür 66 an die Seitenwand 65 seitlich angedockt ist. Nach Öffnen der Türen 66 und 67 können die Substrate 11 aus der angedockten Box 13' zur Handhabung in den Kammern 42' bis 44' entnommen und wieder in die entsprechende Box 13' zurückgeführt werden. Es versteht sich, dass längs dieses Korridors 59' zwischen Gehäuseaußenwand und Seitenwand 65 ein oder mehrere derartige Hubvorrichtungen 47' zusammen mit Schleuseneinheiten 18' angeordnet sein können. Bei diesem Beispiel ist die Box 13' nicht über den Boden sondern an einem Bereich ihrer Haube 64' zur Entnahme von Substraten 11 zu öffnen.

Die weiteren Bauteile der Einrichtung 10' (Figur 3) entsprechen denen der Einrichtung 10 (Figur 1 und 2), wobei die Knickarmgabel 36' der Handhabungsvorrichtung 31' an die Ausführung der Box 13' angepaßt ist, deren Haube 64' obenseitig mit einer Handhabe 69 versehen ist.

Auf diese Weise können in einer einheitlichen Einrichtung 10 bzw. 10' verschiedene Schritte der Produktion, der Behandlung, der Prüfung, der Klassifizierung, der Identifizierung einschließlich der Lagerung und Neuzusammenstellung von Losen von Substraten 11 innerhalb einer Kassette 12, 12' erreicht werden.

## Patentansprüche

1. Einrichtung (10) zum Handhaben von Substraten (11) innerhalb und außerhalb eines Reinstarbeitsraumes (15), mit einer zwischen einem Lagerraum (20) und dem Reinstarbeitsraum (15) vorgesehenen Schleusenvorrichtung (17), mittels der eine unter Reinstraumbedingungen in einer Box (13) untergebrachte Substratkassette (12) aus der Box (13) nehmbar bzw. in diese bringbar ist, und mit einer ersten Handhabungsvorrichtung (51), mittels der die Substrate (11) in der Kassette (12) ablegbar und aus dieser nehmbar sind, wobei der für mehrere Boxen (13) ausgebildete Lagerraum (20) in zwei sich im Wesentlichen gegenüberliegenden Reihen- und/oder Spaltenanordnungen von Lagerplätzen (28, 29) untergebracht ist, **dadurch gekennzeichnet, dass** zwischen den Reihen- und/oder Spaltenanordnungen von Lagerplätzen (28, 29)eine zweite, eine bewegbare Knickarmgabel (36) aufweisende Handhabungsvorrichtung (31) für einen Transfer zwischen den zwei sich gegenüberliegenden Reihen- und/oder Spaltenanordnungen von Lagerplätzen (28, 29) angeordnet und montiert ist, wobei die zweite Handhabungsvorrichtung in drei Koordinatenachsen bewegbar ist und entlang von zwei Koordinatenachsen der gegenüberliegenden Reihen- und/oder Spaltenanordnungen von Lagerplätzen (28, 29) positionierbar ist, und dass die ganze Grundfläche des Reinstarbeitsraumgehäuses (16) im Wesentlichen von einer Grundfläche des Lagerraumgehäuses (21) bedeckt ist.

2. Einrichtung nach Anspruch 1, **dadurch gekennzeichnet, dass** die zweite Handhabungsvorrichtung (31) entlang der zwei Koordinatenachsen bewegbar ist, um die zweite Handhabungsvorrichtung (31) benachbart zu jeder der Kassettenboxen (13) auf den Lagerplätzen (28, 29) im Lagerraum (20) zu positionieren und dass die Schleusenvorrichtung (17) eine oder mehrere voneinander unabhängige Schleuseneinheiten (18) aufweist.

3. Einrichtung nach Anspruch 2, **dadurch gekennzeichnet, dass** die Schleusentür jeder Schleuseneinheit (18) durch ein Bauteil (63, 67) der Kassettenbox (13) gebildet ist.

4. Einrichtung nach mindestens einem der Ansprüche 1 bis 3, **dadurch gekennzeichnet, dass** die Schleusenvorrichtung (17) im Boden (24) des Lagerraums (20) bzw. der Decke des Reinstarbeitsraumes (15) angeordnet ist.

5. Einrichtung nach den Ansprüchen 3 und 4, **dadurch gekennzeichnet, dass** die Schleusentür durch die Plattform (63) der Kassettenbox (13) gebildet ist.

6. Einrichtung nach mindestens einem der Ansprüche 1 bis 3, **dadurch gekennzeichnet, dass** die Schleusenvorrichtung (17) in einer Seitenwand des Reinstarbeitsraumes (15) angeordnet ist.

7. Einrichtung nach den Ansprüchen 3 und 6, **dadurch gekennzeichnet, dass** die Schleusentür (67) in einer Haube (64) der Kassettenbox (13) gebildet ist.

8. Einrichtung nach mindestens einem der Ansprüche 2 bis 7, **dadurch gekennzeichnet, dass** jeder Schleuseneinheit (18) eine Hubvorrichtung (47) für die Substratkassette (12) oder die Kassettenbox (13) zugeordnet ist.

9. Einrichtung nach mindestens einem der vorhergehenden Ansprüche, **dadurch gekennzeichnet, dass** der Reinstarbeitsraum (15) mit mehreren Arbeitskammern (42 bis 44) für Prozeß-, Fertigungs-, Prüf-, Sortier- und/oder dgl. Vorgänge versehen ist, zwischen denen untereinander und/oder zwischen denen und dem oder den Orten der Substratkassette (12) die erste Handhabungsvorrichtung (51) vorgesehen ist.

10. Einrichtung nach Anspruch 9, **dadurch gekennzeichnet, dass** die erste Handhabungsvorrichtung (51) am Boden (24) des Reinstarbeitsraumes (15) mit einer Linearführung (53) versehen ist.

11. Einrichtung nach Anspruch 10, **dadurch gekennzeichnet, dass** die zweite Handhabungsvorrichtung (31) boden- und/oder deckenseitig mit einer Linearführung (33, 34) versehen ist.

12. Einrichtung nach mindestens einem der vorhergehenden Ansprüche, **dadurch gekennzeichnet, dass** der Lagerraum (20) mit einer oder mehreren Ein-/Ausgangsöffnungen (22, 23) für die Kassettenboxen (13) versehen ist.

13. Einrichtung nach Anspruch 12, **dadurch gekennzeichnet, dass** die Ein-/Ausgabeöffnungen (22, 23) verschließbar sind.

14. Einrichtung nach Anspruch 12 oder 13, **dadurch gekennzeichnet, dass** den Ein-/Ausgabeöffnungen (22, 23) eine manuelle oder automatische Beschickungsvorrichtung zugeordnet ist.

15. Einrichtung nach mindestens einem der vorhergehenden Ansprüche, **dadurch gekennzeichnet, dass** die Handhabungsvorrichtung (31, 51) mit einer Gabel- oder Greifereinheit versehen ist.

## Claims

1. Device (10) for manipulating substrates (11) inside and outside an ultraclean workroom (15) with a sluice device (17) provided between a storage room (20) and the ultraclean workroom (15), by means of which sluice device (17) a substrate cassette (12) accommodated under ultraclean room conditions in a box (13) can be removed from the box (13) or introduced into this box, and with a first manipulating device (51) by means of which the substrates (11) can be placed in the cassette (12) and removed from this cassette, wherein the storage room (20) provided for a multiplicity of boxes (13) is accommodated in two substantially opposite row and/or column arrangements of storage spaces (28, 29), **characterized in that** a second manipulating device (31) comprising a movable articulated-arm fork (36) is arranged and mounted between the row and/or column arrangements of storage spaces (28, 29) for a transfer between the two opposite row and/or column arrangements of storage spaces (28, 29), wherein the second manipulating device can be moved in three coordinate axes and can be positioned along two coordinate axes of the opposite row and/or column arrangements of storage spaces (28, 29), and that the entire footprint of the ultraclean workroom housing (16) is substantially covered by a footprint of the storage room housing (21).

2. Device according to claim 1, **characterized in that** the second manipulating device (31) is movable along the two coordinate axes, so as to position the second manipulating device (31) next to each of the cassette boxes (13) at the storage spaces (28, 29) in the storage room (20), and that the sluice device (17) comprises one or more mutually independent sluice units (18).

3. Device according to claim 2, **characterized in that** the sluice door of each sluice unit (18) is formed by a component (63, 67) of the cassette box (13).

4. Device according to at least one of claims 1 to 3, **characterized in that** the sluice device (17) is arranged in the floor (24) of the storage room (20) or in the ceiling of the ultraclean workroom (15), respectively.

5. Device according to claims 3 and 4, **characterized in that** the sluice door is formed by the platform (63) of the cassette box (13).

6. Device according to at least one of claims 1 to 3, **characterized in that** the sluice device (17) is arranged in a lateral wall of the ultraclean workroom (15).

7. Device according to claims 3 and 6, **characterized in that** the sluice door (67) is formed in a cover (64) of the cassette box (13).

8. Device according to at least one of claims 2 to 7, **characterized in that** each sluice unit (18) has assigned to it a lifting device (47) for the substrate cassette (12) or for the cassette box (13).

9. Device according to at least one of the preceding claims, **characterized in that** the ultraclean workroom (15) is provided with a plurality of working chambers (42 to 44) for processing, manufacturing, checking, sorting and/or similar operations, with the first manipulating device (51) being provided between them and/or between them and the location(s) of the substrate cassette (12).

10. Device according to claim 9, **characterized in that** the first manipulating device (51) is provided with a linear guide (53) at the bottom (24) of the ultraclean workroom (15).

11. Device according to claim 10, **characterized in that** the second manipulating device (31) is provided with a linear guide (33, 34) on the bottom side and/or on the ceiling side.

12. Device according to at least one of the preceding claims, **characterized in that** the storage room (20) is provided with one or more input/output openings (22, 23) for the cassette boxes (13).

13. Device according to claim 12, **characterized in that** said input/output openings (22, 23) are lockable.

14. Device according to claim 12 or 13, **characterized in that** the input/output openings (22, 23) have a manual or automatic feeding device assigned to them.

15. Device according to at least one of the preceding claims, **characterized in that** the manipulating device (31, 51) is provided with a fork or gripper unit.

## Revendications

1. Dispositif (10) destiné à manipuler des substrats (11) à l'intérieur et à l'extérieur d'un espace de travail ultra-propre (15), ledit dispositif comportant un dispositif de sas (17) qui est prévu entre un espace de stockage (20) et ledit espace de travail ultra-propre (15) et au moyen duquel une cassette (12) pour substrats qui est accommodée dans une boîte (13) dans les conditions de l'espace de travail ultra-propre peut être enlevée de ladite boîte (13) ou introduite dans cette boîte, et comportant un premier dispositif de manipulation (51) au moyen duquel lesdits substrats (11) peuvent être placés dans la cassette (12) et en être enlevés, l'espace de stockage (20) destiné à plusieurs boîtes (13) pour cassettes étant accommodé dans deux ensembles sensiblement opposés de rangées et/ou de colonnes d'endroits de stockage (28, 29), **caractérisé en ce qu'**un deuxième dispositif de manipulation (31), présentant une fourche mobile (36) à bras articulé, est disposé et monté entre les ensembles de rangées et/ou de colonnes d'endroits de stockage (28, 29) pour un transfert entre les deux ensembles opposés de rangées et/ou de colonnes d'endroits de stockage (28, 29), le deuxième dispositif de manipulation pouvant être déplacé selon trois axes de coordonnées et pouvant être positionné selon deux axes de coordonnées desdits ensembles opposés de rangées et/ou de colonnes d'endroits de stockage (28, 29), et **en ce que** la surface de base totale du boîtier (16) de l'espace de travail ultra-propre est sensiblement couverte d'une surface de base du boîtier (21) de l'espace de stockage.

2. Dispositif selon la revendication 1, **caractérisé en ce que** le deuxième dispositif de manipulation (31) est mobile selon les deux axes de coordonnées de manière à positionner le deuxième dispositif de manipulation (31) adjacent à chaque boîte (13) pour cassettes auprès des endroits de stockage (28, 29) dans l'espace de stockage (20), et **en ce que** le dispositif de sas (17) comporte une ou plusieurs unités de sas (18) indépendantes les unes des autres.

3. Dispositif selon la revendication 2, **caractérisé en ce que** la porte de sas de chaque unité de sas (18) est constituée par un composant (63, 67) de la boîte (13) pour cassettes.

4. Dispositif selon au moins une des revendications 1 à 3, **caractérisé en ce que** le dispositif de sas (17) est disposé respectivement dans le fond (24) de l'espace de stockage (20) ou dans le plafond de l'espace de travail ultra-propre (15).

5. Dispositif selon les revendications 3 et 4, **caractérisé en ce que** la porte de sas est constituée par la plate-forme (63) de la boîte (13) pour cassettes.

6. Dispositif selon au moins une des revendications 1 à 3, **caractérisé en ce que** le dispositif de sas (17) est disposé dans une paroi latérale de l'espace de travail ultra-propre (15).

7. Dispositif selon les revendications 3 et 6, **caractérisé en ce que** la porte de sas (67) est ménagée dans un capot (64) de la boîte (13) pour cassettes.

8. Dispositif selon au moins une des revendications 2 à 7, **caractérisé en ce qu'**à chaque unité de sas (18) est associé un dispositif de levage (47) pour la cassette (12) pour substrat ou pour la boîte (13) pour cassettes.

9. Dispositif selon au moins une des revendications précédentes, **caractérisé en ce que** l'espace de travail ultra-propre (15) est pourvu de plusieurs chambres de travail (42 à 44) pour des opérations de procédé, de production, d'essai, de classement et/ou des opérations semblables, le premier dispositif de manipulation (51) étant prévu entre celles-ci et/ou entre celles-ci et l'endroit (ou les endroits) de la cassette (12) pour substrat.

10. Dispositif selon la revendication 9, **caractérisé en ce que** le premier dispositif de manipulation (51) est pourvu d'un guidage linéaire (53) au fond (24) de l'espace de travail ultra-propre (15).

11. Dispositif selon la revendication 10, **caractérisé en ce que** le deuxième dispositif de manipulation (31) est pourvu d'un guidage linéaire (33, 34) du côté fond et/ou du côté plafond.

12. Dispositif selon au moins une des revendications précédentes, **caractérisé en ce que** l'espace de stockage (20) est pourvu d'une ou plusieurs ouvertures d'entrée/de sortie (22, 23) pour les boîtes (13) pour cassettes.

13. Dispositif selon la revendication 12, **caractérisé en ce que** lesdites ouvertures d'entrée/de sortie (22, 23) sont obturables.

14. Dispositif selon la revendication 12 ou 13, **caractérisé en ce qu'**aux ouvertures d'entrée/de sortie (22, 23) est associé un dispositif d'alimentation manuel ou automatique.

15. Dispositif selon au moins une des revendications précédentes, **caractérisé en ce que** le dispositif de manipulation (31, 51) est pourvu d'une fourche ou d'un ensemble de préhension.
